# DEMANDE DE BREVET EUROPEEN

(11) **EP 0 628 826 A1**
(43) Date de publication de la demande: **14.12.1994**
(21) Numéro de dépôt: 94401243.4
(22) Date de dépôt: 06.06.1994
(51) Int. Cl.: G01R 1/20

(54) **Shunt de mesure pour courants élevés, comportant une résistance montée sur un substrat métallique isolé**

(30) Priorité: 09.06.1993 FR 9306906
(71) Demandeur: SOCIETE D'APPLICATIONS GENERALES D'ELECTRICITE ET DE MECANIQUE SAGEM, F-75783 Paris Cédex 16 (FR)
(72) Inventeur: Panhaleux, Patrick, F-95800 Courdimanche (FR); Metzelard, Olivier, F-95800 Cergy Saint Christophe (FR)
(74) Mandataire: Bloch, Gérard

(57) **Abrégé**

Shunt de mesure de courant comportant une résistance de mesure (1) montée sur un substrat métallique isolé (2-3) entre des plots (6-7) agencés pour recevoir des conducteurs d'alimentation (12-13) du shunt, dans lequel les plots de contact (6-7) sont agencés pour être disposés entre les conducteurs (12-13) et le substrat métallique isolé (2-3) et qu'il est prévu des moyens de serrage (8-11) des conducteurs (12-13) contre les plots (6-7).

Application aux voitures électriques

## Description

Pour mesurer un courant traversant un circuit, on utilise un shunt que l'on insère en série dans le circuit. Par exemple, dans une voiture à propulsion électrique, on mesure le courant d'alimentation du moteur afin de le régler en fonction des commandes du conducteur.

Le shunt comporte une résistance étalon reliée au circuit par une paire de conducteurs d'alimentation aboutissant à deux bornes de raccordement.

La chute de tension à travers la résistance est représentative du courant la traversant. Comme, à fort courant, la chute de tension dans les conducteurs d'alimentation n'est pas négligeable devant la chute à travers la résistance, la tension à mesurer n'est pas prélevée entre les bornes de raccordement mais est mesurée à travers une paire de liaisons de mesure reliées aussi à la résistance et aboutissant à deux bornes de mesure. La mesure ne détournant que peu de courant, la valeur de la résistance des liaisons de mesure n'est pas critique pour la précision de la mesure.

Afin d'assurer un refroidissement de la résistance, celle-ci est montée sur un substrat métallique isolé (SMI). Ce dernier comporte une plaque métallique de refroidissement recouverte d'une couche isolante portant la résistance et une couche de cuivre. La couche de cuivre est gravée pour former deux paires de pistes constituant les conducteurs d'alimentation et les liaisons de mesure reliant les bornes de raccordement et les bornes de mesure, en bord du substrat, à deux plots de cuivre encadrant la résistance et fixés à celle-ci.

Un tel shunt présente cependant l'inconvénient de ne permettre que la mesure de courants limités, car, sinon, les pistes des conducteurs d'alimentation présenteraient une chute de tension trop élevée, qui pourrait les détruire ou simplement perturber le circuit dans lequel est inséré le shunt et fausser la mesure. On peut songer à augmenter la largeur de ces pistes, mais au-delà d'une certaine limite il faudrait augmenter la surface du substrat, ce qui accroîtrait le coût du shunt et en diminuerait la facilité d'emploi.

La présente invention vise à pallier cet inconvénient.

A cet effet, elle concerne un shunt de mesure de courant comportant une résistance de mesure montée sur un substrat métallique isolé entre des plots agencés pour recevoir des conducteurs d'alimentation du shunt, caractérisé par le fait que les plots de contact sont agencés pour être disposés entre les conducteurs et le substrat métallique isolé et qu'il est prévu des moyens de serrage des conducteurs contre les plots.

Ainsi, comme les plots reçoivent les conducteurs d'alimentation, on peut leur donner une section suffisante pour qu'ils ne présentent pratiquement pas, même à fort courant, de chute de tension. Comme les plots sont en contact avec la résistance, cette dernière peut ainsi être traversée par de forts courants sans chute de tension parasite entre elle et les conducteurs d'alimentation.

Avantageusement encore, les moyens de serrage comportent des tiges filetées solidaires des plots pour recevoir les conducteurs.

Les conducteurs peuvent alors être percés et empilés sur les tiges et serrés contre les plots par des écrous ou des papillons de serrage.

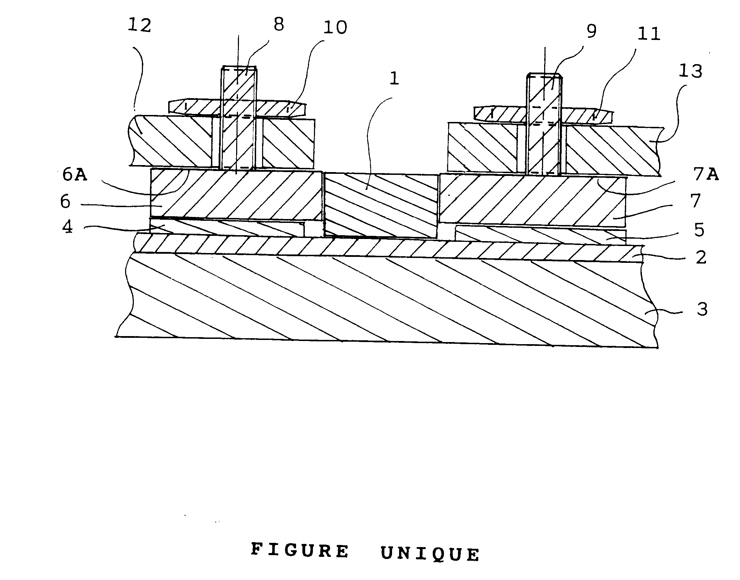

L'invention sera mieux comprise à l'aide de la description suivante de la forme de réalisation préférée du shunt de l'invention, en référence à la figure unique du dessin annexé, qui en est une vue en coupe.

Le shunt de l'invention comporte une résistance étalon 1 dont le matériau est ici l'alliage de la marque protégée Manganine, montée sur un film isolant 2 d'un substrat métallique 3. Sur le film isolant 2, adhèrent deux bandes de cuivre 4-5 parallèles, s'étendant perpendiculairement au plan de la figure et sur lesquelles sont respectivement soudés deux plots 6-7 en cuivre, ici à section rectangulaire dans le plan de la figure, encadrant la résistance 1 et reliés électriquement à elle par leur tranche.

Deux tiges filetées 8-9 sont respectivement serties sur la face 6A-7A des plots 6-7 opposée au substrat 3, ici perpendiculairement à cette face 6A-7A. Deux écrous 10-11 sont prévus sur les tiges 8-9 pour serrer respectivement des barres percées 12-13 ou des cosses de liaison avec un circuit externe fournissant le courant à mesurer sur les faces 6A-7A.

On comprendra qu'il peut être prévu d'autres moyens que les tiges 8-9 et les écrous 10-11, par exemple des moyens purement élastiques, pour assurer un bon contact électrique, sur une grande surface (6A-7A) entre les plots 6-7 et des conducteurs d'alimentation en courant tels que barres, cosses ou tresses. De même, l'orientation des faces 6A-7A ne peut que faciliter l'utilisation du shunt mais n'a pas un caractère impératif.

## Revendications

1. Shunt de mesure de courant comportant une résistance de mesure (1) montée sur un substrat métallique isolé (2-3) entre des plots (6-7) agencés pour recevoir des conducteurs d'alimentation (12-13) du shunt, caractérisé par le fait que les plots de contact (6-7) sont agencés pour être disposés entre les conducteurs (12-13) et le substrat métallique isolé (2-3) et qu'il est prévu des moyens de serrage (8-11) des conducteurs (12-13) contre les plots (6-7).

2. Shunt selon la revendication 1, dans lequel les moyens de serrage (8-11) sont agencés pour recevoir des barres d'alimentation (12-13).

3. Shunt selon l'une des revendications 1 et 2, dans lequel les moyens de serrage (8-11) comportent des tiges filetées (8-9) solidaires des plots (6-7) pour recevoir les conducteurs (12-13).

4. Shunt selon l'une des revendications 1 à 3, dans lequel les moyens de serrage (8-11) sont agencés pour recevoir un conducteur d'alimentation (12-13) par une portion de conducteur (6A;7A) s'étendant sensiblement parallèlement au substrat (2-3).

5. Shunt selon l'une des revendications 1 à 4, dans lequel la résistance (1) comporte l'alliage de la marque Manganine.
